# EUROPEAN PATENT SPECIFICATION

(11) **EP 4 496 166 B1**
(45) Date of publication and mention of the grant of the patent: **11.11.2026**
(21) Application number: 23865905.6
(22) Date of filing: 15.09.2023
(51) Int. Cl.: H02J 3/32, H02J 1/102, H02J 7/34, H02J 7/50, H02J 7/90

(54) **POWER CONTROL DEVICE AND METHOD FOR CONTROLLING DC-DC CONVERTER**
LEISTUNGSSTEUERUNGSVORRICHTUNG UND VERFAHREN ZUR STEUERUNG EINES GLEICHSPANNUNGSWANDLERS
DISPOSITIF DE COMMANDE DE PUISSANCE ET PROCÉDÉ DE COMMANDE DE CONVERTISSEUR CC-CC

(30) Priority: 16.09.2022 KR 20220116817
(43) Date of publication of application: 22.01.2025
(73) Proprietor: LG Energy Solution, Ltd., Seoul 07335 (KR)
(72) Inventor: PARK, Mi So, Daejeon 34122 (KR)
(74) Representative: BCKIP Part mbB
(86) International application number: PCT/KR2023/013941
(87) International publication number: WO 2024/058610

(56) References cited:
- DE-A1- 102020 122 686
- JP-A- 2019 054 716
- KR-A- 20190 130 415
- KR-B1- 102 198 040
- KR-B1- 102 403 951
- US-A1- 2013 127 396
- US-A1- 2015 001 932
- US-A1- 2020 290 475

## Description

The present invention relates to a power control apparatus, a method and an energy storage system for controlling output of a battery using a DC-DC converter to stabilize the voltage of a DC link.

### [Background Art]

An energy storage system relates to renewable energy, a battery that stores electric power, and the power grid. Recently, as the spread of smart grid and renewable energy is expanding and the efficiency and the stability of the power system are emphasized, a demand for energy storage systems in home for power supply and demand control and power quality improvement is increasing. Generally, the output and capacity of home energy storage systems vary depending on purpose of use.

For example, a home energy storage system is applied with a solar power system (Photo Voltaic; PV) and may include a battery section consisting of multiple batteries, a battery management system (BMS) for battery management, a power conversion system (PCS), an energy management system (EMS), and a DC/DC converter, etc.

Meanwhile, in a home energy storage system, when power consumption in a load exceeds a rated power, the PCS may be discharged to stabilize the load. Accordingly, the voltage of the DC link unit may temporarily fluctuate, thereby resulting in ripple.

Generally, home energy storage systems stabilize the DC link by sending ripple current into the grid direction when ripple occurs in the DC link.

However, when a power outage occurs that limits use of the grid, the home energy storage system cannot flow ripple current into the direction of the grid, which has the disadvantage of reducing power efficiency delivered to the load.

In addition, when a user starts using a load in a power outage situation, a high peak voltage that temporarily exceeds an appropriate range may be generated in the DC link. Accordingly, the PCS and multiple batteries in a conventional home energy storage system have the disadvantage of being shut down to prevent failure due to overvoltage.

US 2013/127396 A1 described that in installations for generating alternative energy it is necessary due to the fluctuating availability of the alternative energy source to provide electrical energy stores which can temporarily store excess energy or can compensate for energy bottlenecks. The document describes such an electrical energy store having a bidirectional DC/DC converter (DC) with a low-voltage side and a high-voltage side which can be connected via the high-voltage side to a DC bus (6) and which has a switching hysteresis (SH) with a charging and/or discharge curve, wherein the power consumption and/or the power output is dependent on the voltage on the high-voltage side.

U US 2015/001932 A1 discloses a power conversion device including a solar panel, a first DC/DC conversion circuit, a DC/AC conversion circuit connected via a DC bus, a second DC/DC conversion circuit for controlling bus voltage in the case of power outage, a first control section having two kinds of control modes and controlling the first DC/DC conversion circuit, a second control section for controlling the second DC/DC conversion circuit, and a third control section for controlling the DC/AC conversion circuit. The second control section controls bus voltage in the case of power outage, and the first control section switches the control mode based on information of the second control section. Further background art is disclosed in document DE 10 2020 122686 A1.

### [Detailed Description of the Invention]

### [Technical Problem]

To obviate one or more problems of the related art, the present invention provides a power control apparatus controlling a DC/DC converter as defined in the attached independent claim 1.

To obviate one or more problems of the related art, the present invention also provides a power control method controlling a DC/DC converter as defined in the attached independent claim 6.

To obviate one or more problems of the related art, the present invention also provides an energy storage system including a power control apparatus configured to control a DC/DC converter as defined in the attached independent claim 11. Further advantageous embodiments and improvements of the invention are listed in the dependent claims.

### [Technical Solution]

According to the invention, a power control apparatus, which is connected to a converter performing Direct current/Direct current (DC/DC) conversion between a battery and a power conversion system (PCS), includes a memory and a processor executing at least one instruction in the memory, and the at least one instruction includes an instruction to detect a voltage of DC link between an input terminal of the PCS and an output terminal of the converter; and an instruction to control the output power of the battery based on a change in output power of the PCS which is in accordance with a change in the voltage of DC link.

Here, the instruction to control the output power of the battery may include an instruction to control the output power of the battery by controlling current of the battery.

According to the invention, the instruction to control the output power of the battery includes an instruction to control the battery to output power with a predefined peak power value when the output power of the PCS exceeds a predefined rated power of the battery.

According to the invention, the instruction to control the battery to output power with the predefined peak power value includes an instruction to, upon a peak power output period of the battery being equal to or longer than a predefined first period of time, compare difference between the output power of the PCS and the output power of the battery with a predefined threshold value; and an instruction to control the battery to output power at rated power in the instance that the difference is less than the predefined threshold value.

Meanwhile, the instruction to control the battery to output power with the predefined peak power value may include an instruction to control the battery to output power stepwise to rated power in the instance that the difference is greater than or equal to the predefined threshold value.

Here, the instruction to control the battery to output power stepwise to rated power may include an instruction to control the battery to output power by reducing the output power stepwise during a predefined second period of time based on the peak power of the battery.

In addition, the instruction to control the battery to output power stepwise to rated power may further include an instruction to control the battery to output power at rated power when the peak power output period exceeds the predefined second period of time.

According to the invention, a power control method performed by a power control apparatus, which is connected to a converter performing Direct current/Direct current (DC/DC) conversion between a battery and a power conversion system (PCS) and configured to control output power of a battery, includes detecting a voltage of DC link between an input terminal of the PCS and an output terminal of the converter; and controlling the output power of the battery based on a change in output power of the PCS which is in accordance with a change in the voltage of DC link.

The controlling the output power of the battery may include controlling the output power of the battery by controlling current of the battery.

According to the invention, the controlling the output power of the battery includes controlling the battery to output power with a predefined peak power value when the output power of the PCS exceeds a predefined rated power of the battery.

Also according to the invention, the controlling the battery to output power with the predefined peak power value may include, upon a peak power output period of the battery being equal to or longer than a predefined first period of time, comparing difference between the output power of the PCS and the output power of the battery with a predefined threshold value; and controlling the battery to output power at rated power in the instance that the difference is less than the predefined threshold value.

The controlling the battery to output power with the predefined peak power value may include controlling the battery to output power stepwise to rated power in the instance that the difference is greater than or equal to the predefined threshold value.

The controlling the battery to output power stepwise to rated power may include controlling the battery to output power by reducing the output power stepwise by the threshold power amount during a predefined second period of time based on the peak power of the battery.

The controlling the battery to output power stepwise to rated power may include controlling the battery to output power at rated power when the peak power output period exceeds the predefined second period of time.

According to the invention, an energy storage system includes a battery rack; a plurality of converters configured to perform Direct current/Direct current (DC/DC) conversion in conjunction with the battery rack; a power conversion system (PCS) connected to the DC/DC converter and load; and a power control apparatus connected to the DC/DC converter and configured to control the operation of the DC/DC converter, wherein the converters are operated by the power control apparatus which is configured to detect a voltage of a DC link between an input terminal of the PCS and an output terminal of the converter and to control the output power of the battery based on a change in output power of the PCS which is in accordance with a change in the voltage of the DC link.

The plurality of converters may be operated, by the power control apparatus, to control the output power of the battery by controlling current of the battery.

According to the invention, the plurality of converters are operated, by the power control apparatus, to control the battery to output power with a predefined peak power value when the output power of the PCS exceeds a predefined rated power of the battery.

According to the invention, the plurality of converters are operated, by the power control apparatus, to: upon a peak power output period of the battery being equal to or longer than a predefined first period of time and the difference between the output power of the PCS and the rated power of the battery being less than the predefined threshold value, control the battery to output power at rated power

The plurality of converters may be operated, by the power control apparatus to control the battery to output power stepwise to rated power.

The plurality of converters may be operated, by the power control apparatus, to control the battery to output power by reducing the output power stepwise by the threshold power amount during a predefined second period of time based on the peak power of the battery.

The plurality of converters may be operated, by the power control apparatus, to control the battery to output power at rated power when the peak power output period exceeds the predefined second period of time.

### [Advantageous Effects]

The power control apparatus and method according to embodiments of the present invention may monitor the output power of the PCS, detect changes in the voltage of the DC link, and control the output power of the battery by comparing the output power of the PCS with the rated power of the battery, and thus, provides stabilization of the energy storage system by preventing voltage fluctuations in the DC link.

### [Brief Description of the Drawings]

FIG. 1 is a block diagram of an energy storage system to which the present invention may be applied.
FIG. 2 is a block diagram of an energy storage system in a power outage situation.
FIG. 3 is a block diagram of a power control apparatus according to embodiments of the present invention.
FIG. 4 is a flowchart of a power control method according to embodiments of the present invention.
FIG. 5 is a flowchart for explaining the step of controlling the output power of the battery in the power control method according to embodiments of the present invention.
FIG. 6 is a block diagram for explaining a power control method according to embodiments of the present invention.
FIG. 7 is a graph of voltage change over time in the DC link according to FIG. 6.
FIG. 8 is a flowchart to explain the step of controlling the output power of the battery stepwise in the power control method according to embodiments of the present invention.
FIG. 9 is a graph of battery output power control over time according to FIG. 8
FIG. 10 is a block diagram for explaining a power control method according to another embodiment of the present invention.
FIG. 11 is a graph of voltage change over time in the DC link according to FIG. 10.

100: BMS
200: BSC
300: PMS
400: PCS
500: DC/DC converter
600: grid
700: load
M: memory
P: processor

### [Best Modes for Practicing the Disclosure]

Specific embodiments of the invention are shown by way of example in the drawings and will be described in detail below.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Hereinafter, exemplary embodiments of the present invention will be described in detail with reference to the accompanying drawings.

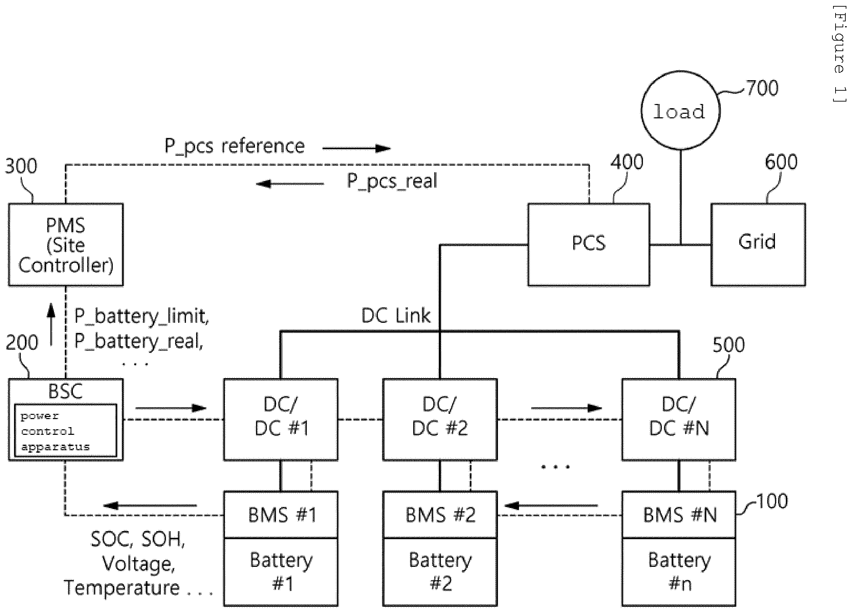

FIG. 1 is a block diagram of an energy storage system to which the present invention may be applied.

Referring to FIG. 1, a basic unit of a battery that stores power in an energy storage system is typically a battery cell. A series/parallel combination of battery cells may form a battery pack and multiple battery packs may form a battery rack. In other words, a battery rack may be a basic unit of a battery system by combining battery packs in series/parallel. Here, the battery pack may be referred to as a battery module, depending on a device or system in which the battery is used. For example, battery #1, battery #2,..., and battery #N shown in FIG. 1 may be in the form of a battery pack or battery rack.

Here, a battery management system (BMS) 100 may be installed for each battery. The BMS 100 may monitor a current, a voltage and a temperature of each battery pack (or rack) to be managed, calculate a state of charge (SOC) of the battery based on a monitoring result to control charging and discharging.

Meanwhile, a battery system controller (BSC) may be located in each battery section which includes a plurality of batteries, peripheral circuits, and devices. The battery system controller 200 may monitor and control objects such as a voltage, a current, a temperature, and a circuit breaker in the battery section. In addition, the BSC 200 may calculate output of each DC-DC converter based on state information of monitored batteries and deliver it to at least one DC-DC converter.

In addiiton, a power conversion system (PCS) 400 installed in each battery section may control power supplied from the outside and power supplied from the battery section to the outside, thereby controlling charging and discharging of the battery. The power convertion system may include a DC/AC inverter.

Furthermore, the output of the DC/DC converter 500 may be connected to the PCS 400 and the PCS 400 may be connected to the power grid 600 and the load 700. Here, the PCS 400 typically operates in a constant power mode. A power management system (PMS) 300 connected to the PCS may control the output of the PCS based on the monitoring and control results of the battery management system or the battery system controller.

In the energy storage system of FIG. 1, battery #1 is connected to DC/DC converter #1, battery #2 is connected to DC/DC converter #2, and battery #N is connected to DC/DC #N. The output of the DC/DC converter corresponding to each battery is connected to the PCS 400 through a DC link.

The DC/DC converter may be a bidirectional converter, wherein when conversion is performed from the battery to the load direction, the input of the DC/DC converter is connected to a battery (a battery cell, a battery pack(module), or a battery rack) and the output of the DC/DC converter may be connected to the load. As examples of the DC/DC converter, various types of converters such as a full-bridge converter, a half-bridge converter, and a flyback converter may be used.

Meanwhile, communication among the BMS 100, the BSC 200, the PMS 300, and the PCS 400 may be implemented through a controller area network (CAN) or Ethernet (indicated by a dotted line in FIG. 1).

In such an energy storage system, a central controller within the system may generally calculate an output value of the battery at every moment and transmit the calculated value as a command to each battery (higher level control). However, higher-level control is possible only when the system voltage of the energy storage system is maintained, that is, lower-level control is preceded.

Meanwhile, the DC link, which is the area between the DC/DC converter and the PCS, has a DC voltage and the voltage of the DC link may generally be called a system voltage.

The voltage of the DC link needs to be maintained at a constant level for stability of the entire energy storage system.

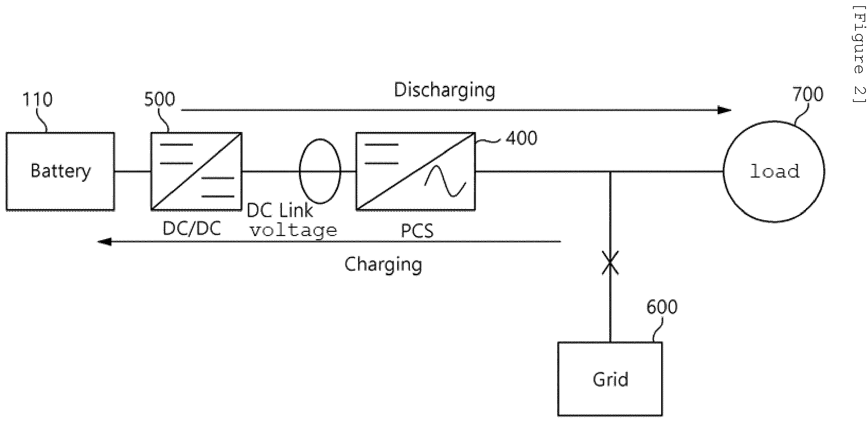

FIG. 2 is a block diagram of an energy storage system in a power outage situation.

Referring to FIG. 2, the power control apparatus according to embodiments of the present invention, as described above, may control the DC/DC converter (500) to maintain the voltage of the DC link, which is the system voltage, in a constant state.

In general, when power consumption occurs in the load 700, the PCS 400 may output power equal to the size of the output reference (power value to be output by the PCS) calculated by the PMS 300 in FIG. 1. Here, the DC voltage on the DC link may temporarily fluctuate, resulting in ripple voltage. Accordingly, the PCS 400 may controls the size of the output power so that the size of the ripple voltage of the DC link is generated within an appropriate range.

In addition, when power consumption exceeding rated power is generated from the load 700, the voltage of the DC link may also fluctuate. Accordingly, the PCS 400 may receive additional power from the grid 600 or output power into the direction of the grid 600 to control the ripple voltage in the DC link to be maintained within an appropriate range.

However, use of the grid 600 may be restricted when a power outage occurs, so the PCS 400 cannot receive power from the grid 600 and cannot send ripple voltage toward the grid 600. Thus, the power efficiency of the energy storage system may be reduced due to the ripple voltage.

Additionally, in a power outage situation, if the load is operated without notice by a user, a high peak voltage that temporarily exceeds an appropriate range may be generated in the DC link. Accordingly, each of the PCS 400 and the battery 500 may shut down its operation through a protection circuit to prevent failure due to the peak voltage.

Accordingly, the power control apparatus according to embodiments of the present invention may use the DC/DC converter 500 to control the output of the battery 110, separately from the output control of the PCS 400, and thus, when a power outage situation in which use of the grid is stopped occurs, the output power of the battery 110 is output at peak power, so that the control burden on the PCS 400 can be reduced even when the load is operated without notice by a user.

In addition, the power control apparatus can increase efficiency of the energy storage system by preventing system interruption due to excessive ripple voltage in the DC link.

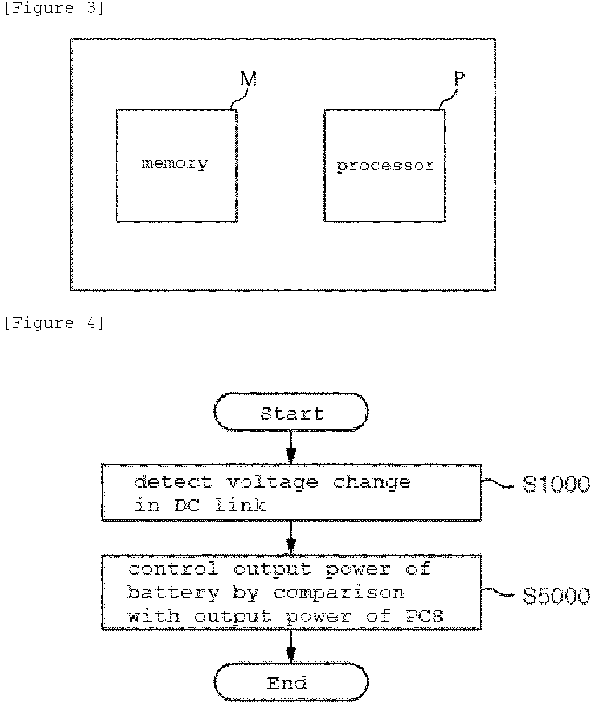

FIG. 3 is a block diagram of a power control apparatus according to embodiments of the present invention.

Referring to FIG. 3, the power control apparatus according to embodiments of the present invention may be provided as a component within the battery system controller (BSC) 200 of FIG. 1, or may be provided as a separate, independent component.

The power control apparatus monitors output power of the PCS 400 and detects a change in the voltage of the DC link according to operation of the load 700.

Additionally, the power control apparatus is connected to a DC/DC converter 500. Accordingly, the power control apparatus controls the DC/DC converter 500 so that output power of a battery 110 is controlled according to the voltage change of the DC link.

Meanwhile, the power control apparatus includes a memory (M) and a processor (P).

According to an embodiment, the memory M may include at least one of a volatile storage medium and a non-volatile storage medium. For example, the memory M may include at least one of read only memory (ROM) and random access memory (RAM).

The memory M includes instructions executed by the processor P.

According to embodiments, the instructions include include an instruction to detect a voltage of DC link between an input terminal of the PCS and an output terminal of the converter; and an instruction to control the output power of the battery based on a change in output power of the PCS which is in accordance with a change in the voltage of DC link.

Here, the instruction to control the output power of the battery may include an instruction to control the output power of the battery by controlling current of the battery.

In addition, the instruction to control the output power of the battery includes an instruction to control the battery to output power with a predefined peak power value when the output power of the PCS exceeds the output power of the battery.

Here, the instruction to control the battery to output power with the predefined peak power value includes an instruction to, upon a peak power output period of the battery being equal to or longer than a predefined first period of time, compare difference between the output power of the PCS and the output power of the battery with a predefined threshold power value; and an instruction to control the battery to output power at rated power in the instance that the difference is less than the predefined threshold power value.

Meanwhile, the instruction to control the battery to output power with the predefined peak power value may include an instruction to, upon a peak power output period of the battery being equal to or longer than a predefined first period of time, compare difference between the output power of the PCS and the output power of the battery with a predefined threshold value; and an instruction to control the battery to output power stepwise to rated power in the instance that the difference is greater than or equal to the predefined threshold value.

Here, the instruction to control the battery to output power stepwise to rated power may include an instruction to control the battery to output power by stepwise reducing the output power during a predefined second period of time based on the peak power of the battery.

In addition, the instruction to control the battery to output power stepwise to rated power may further include an instruction to control the battery to output power at rated power when the peak power output period exceeds the predefined second period of time.

Hereinafter, a power control method according to the operation of the processor P of the power control apparatus will be described in detail.

FIG. 4 is a flowchart of a power control method according to embodiments of the present invention.

Referring to FIG. 4, the power control apparatus detects a voltage change in the DC link (S1000). Here, the DC link is arranged between an input terminal of the PCS (400) and an output terminal of the DC/DC converter (500).

A voltage change of the DC link in a power outage situation may occur depending on output power of the battery 110 and operation timing of the load 700.

According to an embodiment, when a user temporarily operates the load 700 before the output power of the battery 110 is reduced, a voltage change may occur in the DC link.

According to another embodiment, when a user temporarily operates the load 700 after the output power of the battery 110 is reduced, a voltage change may occur in the DC link.

Accordingly, the power control apparatus may detect changes in the voltage of the DC link by continuously monitoring the operating state of the load 700 and changes in output power of the battery 110.

Here, the operating state of the load 700 is controlled by user's actions, so it is difficult to predict in advance. Meanwhile, the PCS 400 provides output power equal to the power consumption of the load 700. Accordingly, the power control apparatus may detect changes in the operating state of the load 700 by continuously monitoring changes in output power of the PCS 400.

When a voltage change in the DC link occurs, the power control apparatus may compare the output power of the PCS 400 and the output power of the battery 110. In other words, the power control apparatus may compare the power consumption of the load 700 and the output power of the battery 110. Accordingly, the power control apparatus may use the DC/DC converter 500 to control the size and speed of the output power of the battery 110 according to the comparison result (S5000). For example, DC/DC converter 500 may be a bidirectional converter.

How the power control apparatus controls the size and speed of the output power of the battery 110 through the DC/DC converter 500 will be described in more detail below.

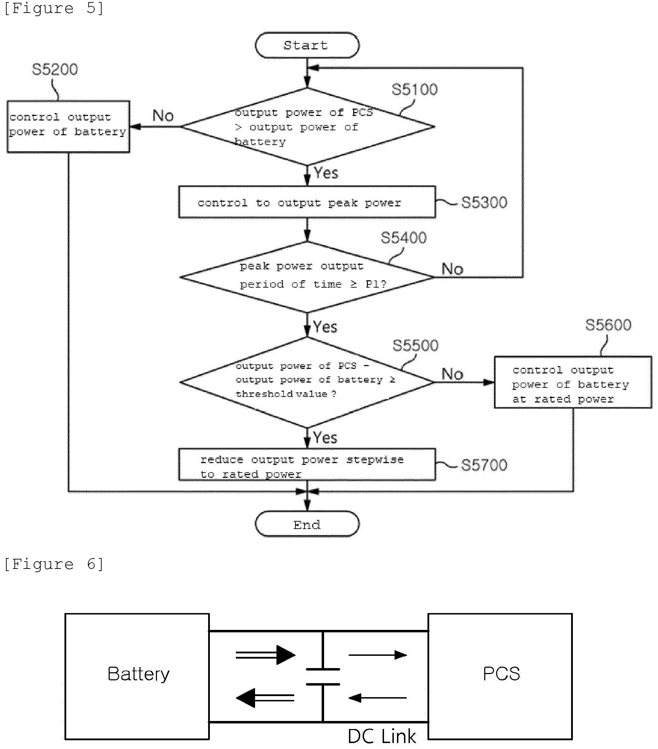

FIG. 5 is a flowchart for explaining the step of controlling the output power of the battery in the power control method according to embodiments of the present invention.

Referring to FIG. 5, the power control apparatus according to embodiments of the present invention may compare output power of the PCS 400 and output power of the battery 110 (S5100).

According to an embodiment, when the output power value of the PCS 400 is less than or equal to the output power value of the battery 110, it may be determined that power consumption of the load 700 is reduced under user's control. Accordingly, the power control apparatus may control an amount of current of the DC/DC converter 500 (S5200) to quickly reduce the output power of the battery 110 at a higher speed than a predefined reference speed.

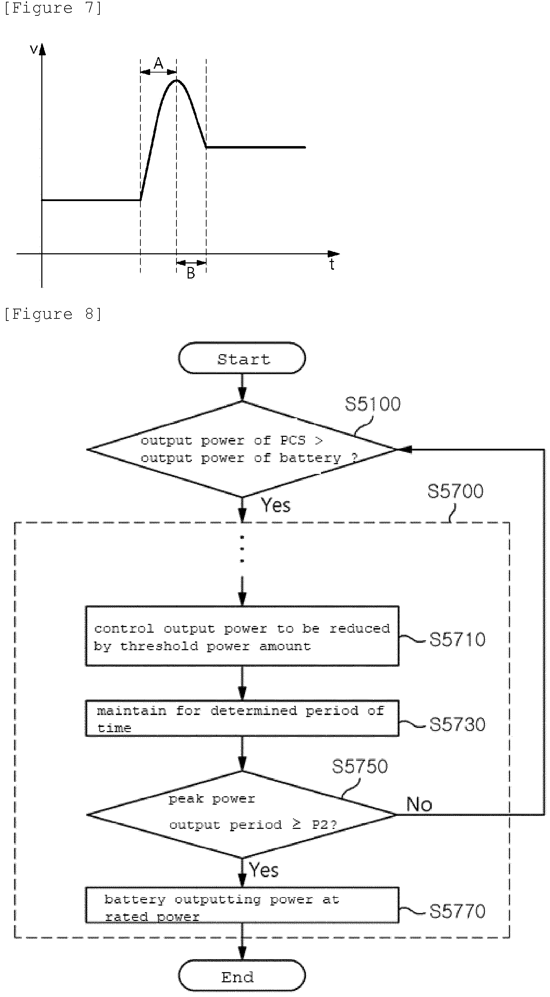

FIG. 6 is a block diagram for explaining a power control method according to embodiments of the present invention. Additionally, FIG. 7 is a graph of voltage change over time in the DC link according to FIG. 6.

Referring to FIGS. 6 and 7, when the power consumption of the load 700 is reduced, the output power of the battery 110 is grearter than the power consumption of the load 700, and thus, a voltage change of the DC link may occur (section A in FIG. 7).

Therefore, the power control apparatus may quickly reduce the output power of the battery 110 by controlling the amount of current of the battery 110 at a high speed using the DC/DC converter 500 (section B in FIG. 7). Accordingly, the voltage of the DC link can be stabilized.

Referring again to FIG. 5, according to another embodiment, when the output power value of the PCS 400 exceeds the output power value of the battery 110, the power control apparatus may operate the DC/DC converter 500 to control the battery 110 to output peak power (S5300), so as to prepare for unexpected operation of the load 700.

In general, upon being powered, the load 700 may temporarily consume peak power and then consume a predefined rated power again. However, operation timing of the load 700 may not be predicted. Therefore, when the output power of the battery 110 becomes lower than the output power of the PCS 400, the power control apparatus according to embodiments of the present invention may first control the battery 110 to operate at peak power for a preset time. Here, the peak power of the battery 110 may be power provided from the battery 110 to support output power above the rated power that is temporarily generated at initial time when power is applied to the load 700. For example, the peak power may be 11 kW. However, since the load 700 is operated under a user's control, the power control apparatus cannot predict an operation time of the load. Additionally, since the battery 110 has limited charge capacity, the battery may provide maximum peak power only for a limited period of time.

According to an embodiment, when the peak power output period of time of the battery 110 is less than a preset first period (P₁) (S5400), the process returns to step S5100 and continuously monitors voltage changes in the DC link by comparing the output power of the PCS 400 and the rated power of the battery 110. For example, the first period (P₁) may be 9.6 sec.

Meanwhile, according to another embodiment, when the peak power output period of time of the battery 110 is equal to or longer than the preset first period of time (P₁) (S5400), the power control apparatus may compare difference between the output power of the PCS 400 and the output power of the battery 110 at the current time with a predetermined threshold value (S5500).

Here, when the difference between the output power of the PCS 400 and the output power of the battery 110 is less than the predetermined threshold value (S5500), the power control apparatus may determine that stable power supply, by the PCS 400, to the load 700 is possible. Accordingly, the power control apparatus may reduce the output power of the battery 110 to the rated power through the DC/DC converter 500 (S5600).

Meanwhile, when the difference between the output power of the PCS 400 and the output power of the battery 110 is equal to or greater than the predetermined threshold value (S5500), the power control apparatus may determine that stably supplying power to the load 700 solely with the output power of the PCS 400 is difficult. Accordingly, the power control apparatus may stepwise reduce the output power of the battery 110 by the DC/DC converter 500 in order to reduce control burden of the PCS 400 (S5700).

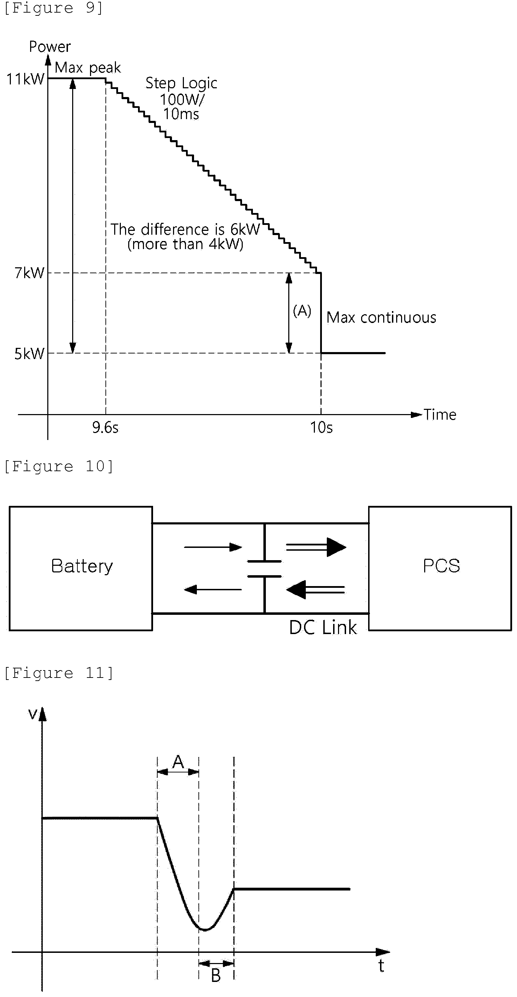

FIG. 8 is a flowchart to explain the step of controlling the output power of the battery stepwise in the power control method according to embodiments of the present invention. Additionally, FIG. 9 is a graph of battery output power control over time according to FIG. 8.

Referring to FIGS. 8 and 9, when the difference between the output power of the PCS 400 and the output power of the battery 110 is greater than or equal to a predetermined threshold value (S5500), the power control apparatus may control the DC/DC converter 500 to reduce the output power of the battery 110 by a predefined threshold power amount (S5710). Here, the predefined threshold power amount may be 100W.

Thereafter, the power control apparatus may control the DC/DC converter 500 to maintain the output power of the battery 110 for a predetermined period of time (S5730). For example, the DC/DC converter 500 may maintain the output power reduced by the predefined threshold power amount for 10 ms.

In other words, the power control apparatus may gradually reduce the output power of the battery with a step logic through the DC/DC converter 500 by a predefined threshold power amount at each preset cycle.

Thereafter, the power control apparatus may compare the peak power output period with a second period of time (P₂) (S5750). Here, the second period of time (P₂) may be a threshold period during which the output power of the battery can be output at more than the rated power. For example, the second period (P₂) may be 10 seconds.

According to an embodiment, when the peak power output period of time of the battery 110 reaches the second period of time (P₂), the power control apparatus may adjust the output power of the battery 110 to rated power (Max Continous) through the DC/DC converter 500 (S5770). For example, the rated power of battery 110 may be 7kW.

Here, the rated power may be preset to any one value within the output range of the rated power (see (A) in FIG. 7). In other words, the output range of the rated power may fall within the output power control range of the PCS 400 for stabilizing the voltage of the DC link. Accordingly, the power control apparatus may control the output power of the battery 110 by reducing the output power of the battery stepwise by the threshold power amount through the DC/DC converter 500 until the period of power control time reaches the second period of time (P₂) .

Meanwhile, according to another embodiment, if the peak power output period of time of the battery 110 is not the same as the second period of time (P₂), the power control apparatus may return to step S5100 and compare the output power of the PCS 400 and the output power of the battery, thereby continuously monitoring voltage changes in the DC link.

FIG. 10 is a block diagram for explaining a power control method according to another embodiment of the present invention. Furthermore, FIG. 11 is a graph of voltage change over time in the DC link according to FIG. 10.

Referring to FIGS. 10 and 11, as in step S5300 of FIG. 5, when the output power value of the battery 110 is smaller than the output power value of the PCS 400, the power control apparatus may control the DC/DC converter 500 to operate the battery 110 at peak power, in order to prepare for a situation that the load 700 is unexpectealy operated by a user. Accordingly, when the load 700 is operated by a user within the peak power output period of the battery 110, the battery 110 may stably supply power despite temporary peak power consumption of the load 700.

Meanwhile, the power control apparatus gradually reduces the output of the peak power in preparation for the load 700 being operated after the peak power output period of the battery 110. Accordingly, when the load 700 is operated during the second period P₂ after the peak power output period of time of the battery 110, the power control apparatus may output the power of the battery 110 above the rated voltage, and thus, voltage fluctuations in the DC link (sections A and B in FIG. 11) can be minimized.

The power control apparatus and method according to embodiments of the present invention have been described above.

The power control apparatus and method according to embodiments of the present invention monitor the output power of the PCS, detect changes in the voltage of the DC link, and control the output power of the battery by comparing the output power of the PCS with the rated power of the battery, and thus, provides stabilization of the energy storage system by preventing voltage fluctuations in the DC link.

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

In addition, the computer-readable recording medium may include naraware devices specially configured to store and execute program instructions, such as ROM, RAM, flash memory, etc. The program instructions may include not only machine language code created by a compiler, but also high-level language code that can be executed by a computer using an interpreter.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

## Claims

1. A power control apparatus, configured to be connected to a converter performing Direct current/Direct current, DC/DC, conversion between a battery (110, 500) and a power conversion system, PCS, configured to control output power of a battery (110, 500), the apparatus comprising:
1.1 a memory; and
1.2 a processor executing instructions in the memory,
wherein the instructions include:
1.2.1 an instruction to detect a voltage of a DC link between an input terminal of the PCS (400) and an output terminal of the converter; and
1.2.2 an instruction to control the output power of the battery (110, 500) based on a change in output power of the PCS (400) which is in accordance with a change in the voltage of the DC link;
**characterized in that**
1.2.3 the instruction to control the output power of the battery (110, 500) includes an instruction to control the battery (110, 500) to output power with a predefined peak power value when the output power of the PCS (400) exceeds a predefined rated power of the battery (110, 500); and
1.2.4 wherein the instruction to control the battery (110, 500) to output power with the predefined peak power value includes:
1.2.4.1 an instruction to, upon a peak power output period of the battery (110, 500) being equal to or longer than a predefined first period of time, compare a difference between the output power of the PCS (400) and the output power of the battery (110, 500) with a predefined threshold value; and
1.2.4.2 an instruction to control the battery (110, 500) to output power at the rated power in an instance that the difference is less than the predefined threshold value

2. The apparatus of claim 1, wherein the instruction to control the output power of the battery (110, 500) includes an instruction to control the output power of the battery (110, 500) by controlling a current of the battery (110, 500).

3. The apparatus of claim 1, wherein the instruction to control the battery to output power with the predefined peak power value includes:
an instruction to control the battery (110, 500) to change the output power stepwise towards the rated power in an instance that the difference is greater than or equal to the predefined threshold value.

4. The apparatus of claim 3, wherein the instruction to control the battery (110, 500) to change the output power stepwise includes:
an instruction to control the battery (110, 500) to output power by reducing the output power stepwise by a threshold power amount during a predefined second period of time based on the peak power of the battery (110, 500).

5. The apparatus of claim 4, wherein the instruction to control the battery (110, 500) to change the output power stepwise further includes:
an instruction to control the battery (110, 500) to output power at the rated power when the peak power output period exceeds the predefined second period of time.

6. A power control method performed by a power control apparatus, which is connected to a converter performing Direct current/Direct current, DC/DC, conversion between a battery (110, 500) and a power conversion system, PCS (400), and controls output power of the battery (110, 500), the method comprising:
detecting a voltage of a DC link between an input terminal of the PCS (400) and an output terminal of the converter; and
controlling the output power of the battery (110, 500) based on a change in output power of the PCS (400) which is in accordance with a change in the voltage of the DC link;
**characterized in that**
the controlling the output power of the battery (110, 500) includes controlling the battery (110, 500) to output power with a predefined peak power value when the output power of the PCS (400) exceeds a predefined rated power of the battery (110, 500);
wherein the controlling the battery (110, 500) to output power with the predefined peak power value includes:
upon a peak power output period of the battery (110, 500) being equal to or longer than a predefined first period of time, comparing a difference between the output power of the PCS (400) and the output power of the battery (110, 500) with a predefined threshold value; and
controlling the battery (110, 500) to output power at the rated power in an instance that the difference is less than the predefined threshold value.

7. The method of claim 6, wherein the controlling the output power of the battery (110, 500) includes controlling the output power of the battery (110, 500) by controlling a current of the battery (110, 500).

8. The method of claim 6, wherein the controlling the battery to output power with the predefined peak power value includes:
controlling the battery (110, 500) to change the output power stepwise towards the rated power in an instance that the difference is greater than or equal to the predefined threshold value.

9. The method of claim 8, wherein the controlling the battery (110, 500) to change the output power stepwise includes:
controlling the battery (110, 500) to output power by reducing the output power stepwise by the threshold power amount during a predefined second period of time based on the peak power of the battery (110, 500).

10. The method of claim 9, wherein the controlling the battery (110, 500) to change the output power stepwise includes:
controlling the battery (110, 500) to output power at the rated power when the peak power output period exceeds the predefined second period of time.

11. An energy storage system, comprising:
a battery rack including a plurality of batteries;
a plurality of converters, each converter configured to perform Direct current/Direct current, DC/DC, conversion in conjunction with one respective battery of the battery rack;
a power conversion system, PCS (400), connected to the DC/DC converters (500) and a load; wherein a DC link connects an input terminal of the PCS and output terminals of the converters; and
a power control apparatus connected to the DC/DC converters (500) and configured to control the operation of the DC/DC converters (500),
wherein the converters are configured to be operated by the power control apparatus which is configured to detect a voltage of the DC link and to control the output power of the battery rack based on a change in output power of the PCS (400) which is in accordance with a change in the voltage of the DC link;
**characterized in that**
the power control apparatus is configured to operate the plurality of converters to control the respective battery of the battery rack to output power with a predefined peak power value when the output power of the PCS exceeds a predefined rated power of the respective battery of the battery rack; and wherein the power control apparatus is configured to operate the plurality of converters to:
upon a peak power output period of the respective battery being equal to or longer than a predefined first period of time, control the respective battery of the battery rack to output power at the rated power in the instance that a difference between the output power of the PCS (400) and the output power of the respective battery of the battery rack is less than a predefined threshold power amount.

12. The system of claim 11, wherein the power control apparatus is configured to operate the plurality of converters to:
control the respective battery of the battery rack to change the output power stepwise towards the rated power in the instance that the difference is equal to or greater than the predefined threshold power amount.

13. The system of claim 12, wherein the power control apparatus is configured to operate the plurality of converters to:
control the respective battery of the battery rack to change the output power by reducing the output power stepwise by the threshold power amount during a predefined second period of time based on the peak power of the battery rack.

14. The system of claim 13, wherein the power control apparatus is configured to operate the plurality of converters to:
control the respective battery of the battery rack to output power at the rated power when the peak power output period exceeds the predefined second period of time.

## Patentansprüche

1. Leistungssteuervorrichtung, die dazu eingerichtet ist, mit einem Wandler verbunden zu werden, der eine Gleichstrom/Gleichstrom-Wandlung (DC/DC-Wandlung) zwischen einer Batterie (110, 500) und einem Leistungswandlungssystem, PCS, durchführt, und die dazu eingerichtet ist, die Ausgangsleistung einer Batterie (110, 500) zu steuern, wobei die Vorrichtung Folgendes umfasst:
1.1 einen Speicher; und
1.2 einen Prozessor, der Anweisungen in dem Speicher ausführt, wobei die Anweisungen Folgendes umfassen:
1.2.1 eine Anweisung zum Erfassen einer Spannung eines Gleichstromzwischenkreises zwischen einem Eingangsanschluss des PCS (400) und einem Ausgangsanschluss des Wandlers; und
1.2.2 eine Anweisung zum Steuern der Ausgangsleistung der Batterie (110, 500) auf Grundlage einer Änderung der Ausgangsleistung des PCS (400), die einer Änderung der Spannung des Gleichstromzwischenkreises entspricht;
**dadurch gekennzeichnet, dass**
1.2.3 die Anweisung zum Steuern der Ausgangsleistung der Batterie (110, 500) eine Anweisung umfasst, die Batterie (110, 500) so zu steuern, dass sie Leistung mit einem vordefinierten Spitzenleistungswert abgibt, wenn die Ausgangsleistung des PCS (400) eine vordefinierte Nennleistung der Batterie (110, 500) überschreitet; und
1.2.4 wobei die Anweisung, die Batterie (110, 500) so zu steuern, dass sie Leistung mit dem vordefinierten Spitzenleistungswert abgibt, Folgendes umfasst:
1.2.4.1 eine Anweisung, wenn ein Zeitraum der Spitzenleistungsabgabe der Batterie (110, 500) gleich einer vordefinierten ersten Zeitdauer oder länger als diese ist, eine Differenz zwischen der Ausgangsleistung des PCS (400) und der Ausgangsleistung der Batterie (110, 500) mit einem vordefinierten Schwellenwert zu vergleichen; und
1.2.4.2 eine Anweisung, die Batterie (110, 500) so zu steuern, dass sie in einem Fall, in dem die Differenz kleiner als der vordefinierte Schwellenwert ist, Leistung in Höhe der Nennleistung abgibt.

2. Vorrichtung nach Anspruch 1, wobei die Anweisung zum Steuern der Ausgangsleistung der Batterie (110, 500) eine Anweisung zum Steuern der Ausgangsleistung der Batterie (110, 500) durch Steuern eines Stroms der Batterie (110, 500) umfasst.

3. Vorrichtung nach Anspruch 1, wobei die Anweisung, die Batterie so zu steuern, dass sie Leistung mit dem vordefinierten Spitzenleistungswert abgibt, Folgendes umfasst:
eine Anweisung, die Batterie (110, 500) so zu steuern, dass sie in einem Fall, in dem die Differenz größer als der vordefinierte Schwellenwert oder gleich diesem ist, die Ausgangsleistung schrittweise in Richtung der Nennleistung ändert.

4. Vorrichtung nach Anspruch 3, wobei die Anweisung, die Batterie (110, 500) so zu steuern, dass sie die Ausgangsleistung schrittweise ändert, Folgendes umfasst:
eine Anweisung, die Batterie (110, 500) so zu steuern, dass sie Leistung abgibt, indem sie die Ausgangsleistung während einer vordefinierten zweiten Zeitdauer auf Grundlage der Spitzenleistung der Batterie (110, 500) schrittweise um einen Schwellenleistungsbetrag verringert.

5. Vorrichtung nach Anspruch 4, wobei die Anweisung, die Batterie (110, 500) so zu steuern, dass sie die Ausgangsleistung schrittweise ändert, ferner Folgendes umfasst:
eine Anweisung, die Batterie (110, 500) so zu steuern, dass sie Leistung in Höhe der Nennleistung abgibt, wenn der Zeitraum der Spitzenleistungsabgabe die vordefinierte zweite Zeitdauer überschreitet.

6. Leistungssteuerverfahren, das von einer Leistungssteuervorrichtung durchgeführt wird, die mit einem Wandler verbunden ist, der eine Gleichstrom/Gleichstrom-Wandlung (DC/DC-Wandlung) zwischen einer Batterie (110, 500) und einem Leistungswandlungssystem, PCS (400), durchführt, und die die Ausgangsleistung der Batterie (110, 500) steuert, wobei das Verfahren Folgendes umfasst:
Erfassen einer Spannung eines Gleichstromzwischenkreises zwischen einem Eingangsanschluss des PCS (400) und einem Ausgangsanschluss des Wandlers; und
Steuern der Ausgangsleistung der Batterie (110, 500) auf Grundlage einer Änderung der Ausgangsleistung des PCS (400), die einer Änderung der Spannung des Gleichstromzwischenkreises entspricht;
**dadurch gekennzeichnet, dass**
das Steuern der Ausgangsleistung der Batterie (110, 500) umfasst, die Batterie (110, 500) so zu steuern, dass sie Leistung mit einem vordefinierten Spitzenleistungswert abgibt, wenn die Ausgangsleistung des PCS (400) eine vordefinierte Nennleistung der Batterie (110, 500) überschreitet;
wobei das Steuern der Batterie (110, 500) zur Abgabe von Leistung mit dem vordefinierten Spitzenleistungswert Folgendes umfasst:
Vergleichen einer Differenz zwischen der Ausgangsleistung des PCS (400) und der Ausgangsleistung der Batterie (110, 500) mit einem vordefinierten Schwellenwert, wenn ein Zeitraum der Spitzenleistungsabgabe der Batterie (110, 500) gleich einer vordefinierten ersten Zeitdauer oder länger als diese ist; und
Steuern der Batterie (110, 500) zur Abgabe von Leistung in Höhe der Nennleistung in einem Fall, in dem die Differenz kleiner als der vordefinierte Schwellenwert ist.

7. Verfahren nach Anspruch 6, wobei das Steuern der Ausgangsleistung der Batterie (110, 500) das Steuern der Ausgangsleistung der Batterie (110, 500) durch Steuern eines Stroms der Batterie (110, 500) umfasst.

8. Verfahren nach Anspruch 6, wobei das Steuern der Batterie zur Abgabe von Leistung mit dem vordefinierten Spitzenleistungswert Folgendes umfasst:
Steuern der Batterie (110, 500) zum schrittweisen Ändern der Ausgangsleistung in Richtung der Nennleistung in einem Fall, in dem die Differenz größer als der vordefinierte Schwellenwert oder gleich diesem ist.

9. Verfahren nach Anspruch 8, wobei das Steuern der Batterie (110, 500) zum schrittweisen Ändern der Ausgangsleistung Folgendes umfasst:
Steuern der Batterie (110, 500) zur Abgabe von Leistung durch schrittweises Verringern der Ausgangsleistung um den Schwellenleistungsbetrag während einer vordefinierten zweiten Zeitdauer auf Grundlage der Spitzenleistung der Batterie (110, 500).

10. Verfahren nach Anspruch 9, wobei das Steuern der Batterie (110, 500) zum schrittweisen Ändern der Ausgangsleistung Folgendes umfasst:
Steuern der Batterie (110, 500) zur Abgabe von Leistung in Höhe der Nennleistung, wenn der Zeitraum der Spitzenleistungsabgabe die vordefinierte zweite Zeitdauer überschreitet.

11. Energiespeichersystem, umfassend:
ein Batteriegestell, das eine Mehrzahl von Batterien umfasst;
eine Mehrzahl von Wandlern, wobei jeder Wandler dazu eingerichtet ist, eine Gleichstrom/Gleichstrom-Wandlung (DC/DC-Wandlung) in Verbindung mit jeweils einer Batterie des Batteriegestells durchzuführen;
ein Leistungswandlungssystem, PCS (400), das mit den DC/DC-Wandlern (500) und einer Last verbunden ist; wobei ein Gleichstromzwischenkreis einen Eingangsanschluss des PCS und Ausgangsanschlüsse der Wandler verbindet; und
eine Leistungssteuervorrichtung, die mit den DC/DC-Wandlern (500) verbunden und dazu eingerichtet ist, den Betrieb der DC/DC-Wandler (500) zu steuern,
wobei die Wandler dazu eingerichtet sind, von der Leistungssteuervorrichtung betrieben zu werden, die dazu eingerichtet ist, eine Spannung des Gleichstromzwischenkreises zu erfassen und die Ausgangsleistung des Batteriegestells auf Grundlage einer Änderung der Ausgangsleistung des PCS (400), die einer Änderung der Spannung des Gleichstromzwischenkreises entspricht, zu steuern;
**dadurch gekennzeichnet, dass**
die Leistungssteuervorrichtung dazu eingerichtet ist, die Mehrzahl von Wandlern zu betreiben, um die jeweilige Batterie des Batteriegestells so zu steuern, dass sie Leistung mit einem vordefinierten Spitzenleistungswert abgibt, wenn die Ausgangsleistung des PCS eine vordefinierte Nennleistung der jeweiligen Batterie des Batteriegestells überschreitet; und wobei die Leistungssteuervorrichtung dazu eingerichtet ist, die Mehrzahl von Wandlern zu betreiben, um:
wenn ein Zeitraum der Spitzenleistungsabgabe der jeweiligen Batterie gleich einer vordefinierten ersten Zeitdauer oder länger als diese ist, die jeweilige Batterie des Batteriegestells so zu steuern, dass sie in dem Fall, in dem eine Differenz zwischen der Ausgangsleistung des PCS (400) und der Ausgangsleistung der jeweiligen Batterie des Batteriegestells kleiner als ein vordefinierter Schwellenleistungsbetrag ist, Leistung in Höhe der Nennleistung abgibt.

12. System nach Anspruch 11, wobei die Leistungssteuervorrichtung dazu eingerichtet ist, die Mehrzahl von Wandlern zu betreiben, um:
die jeweilige Batterie des Batteriegestells so zu steuern, dass sie in dem Fall, in dem die Differenz gleich dem vordefinierten Schwellenleistungsbetrag oder größer als dieser ist, die Ausgangsleistung schrittweise in Richtung der Nennleistung ändert.

13. System nach Anspruch 12, wobei die Leistungssteuervorrichtung dazu eingerichtet ist, die Mehrzahl von Wandlern zu betreiben, um:
die jeweilige Batterie des Batteriegestells so zu steuern, dass sie die Ausgangsleistung ändert, indem sie die Ausgangsleistung während einer vordefinierten zweiten Zeitdauer auf Grundlage der Spitzenleistung des Batteriegestells schrittweise um den Schwellenleistungsbetrag verringert.

14. System nach Anspruch 13, wobei die Leistungssteuervorrichtung dazu eingerichtet ist, die Mehrzahl von Wandlern zu betreiben, um:
die jeweilige Batterie des Batteriegestells so zu steuern, dass sie Leistung in Höhe der Nennleistung abgibt, wenn der Zeitraum der Spitzenleistungsabgabe die vordefinierte zweite Zeitdauer überschreitet.

## Revendications

1. Dispositif de commande de puissance, prévu pour être connecté à un convertisseur exécutant une conversion courant continu/courant continu, CC/CC, entre une batterie (110, 500) et un système de conversion de puissance, PCS, prévu pour commander la puissance de sortie d'une batterie (110, 500), ledit dispositif comprenant :
1.1 une mémoire ; et
1.2 un processeur exécutant des instructions dans la mémoire, lesdites instructions comprenant :
1.2.1 une instruction pour détecter une tension d'une liaison CC entre une borne d'entrée du PCS (400) et une borne de sortie du convertisseur ; et
1.2.2 une instruction pour commander la puissance de sortie de la batterie (110, 500) sur la base d'une variation de puissance de sortie du PCS (400) en fonction d'une variation de tension de la liaison CC ;
**caractérisé en ce que**
1.2.3 l'instruction de commande de la puissance de sortie de la batterie (110, 500) comprend une instruction de commande de la batterie (110, 500) pour délivrer en sortie une puissance avec une valeur de puissance de crête prédéfinie si la puissance de sortie du PCS (400) dépasse une puissance nominale prédéfinie de la batterie (110, 500) ; et
1.2.4 où l'instruction de commande de la batterie (110, 500) pour délivrer en sortie une puissance avec la valeur de puissance de crête prédéfinie comprend :
1.2.4.1 une instruction pour comparer, sur une période de sortie de puissance de crête de la batterie (110, 500) égale ou supérieure à une première période prédéfinie, une différence entre la puissance de sortie du PCS (400) et la puissance de sortie de la batterie (110, 500) avec une valeur seuil prédéfinie ; et
1.2.4.2 une instruction pour commander la batterie (110, 500) afin de délivrer en sortie une puissance à la puissance nominale dans un cas où la différence est inférieure à la valeur seuil prédéfinie.

2. Dispositif selon la revendication 1, où l'instruction de commande de la puissance de sortie de la batterie (110, 500) comprend une instruction de commande de la puissance de sortie de la batterie (110, 500) par commande d'un courant de la batterie (110, 500).

3. Dispositif selon la revendication 1, où l'instruction de commande de la batterie pour délivrer en sortie une puissance avec la valeur de puissance de crête prédéfinie comprend :
une instruction pour commander la batterie (110, 500) afin de modifier progressivement la puissance de sortie jusqu'à la puissance nominale dans un cas où la différence est supérieure ou égale à la valeur seuil prédéfinie.

4. Dispositif selon la revendication 3, où l'instruction de commande de la batterie (110, 500) pour modifier progressivement la puissance de sortie comprend :
une instruction de commande de la batterie (110, 500) pour délivrer en sortie une puissance par réduction progressive de la puissance de sortie d'une valeur de puissance seuil pendant une deuxième période prédéfinie sur la base de la puissance de crête de la batterie (110, 500).

5. Dispositif selon la revendication 4, où l'instruction de commande de la batterie (110, 500) pour modifier progressivement la puissance de sortie comprend en outre :
une instruction de commande de la batterie (110, 500) pour délivrer en sortie une puissance à la puissance nominale si la période de sortie de puissance de crête dépasse la deuxième période prédéfinie.

6. Procédé de commande de puissance exécuté par un dispositif de commande de puissance, connecté à un convertisseur exécutant une conversion courant continu/courant continu, CC/CC, entre une batterie (110, 500) et un système de conversion de puissance, PCS (400), et commandant une puissance de sortie de la batterie (110, 500), ledit procédé comprenant :
la détection d'une tension d'une liaison CC entre une borne d'entrée du PCS (400) et une borne de sortie du convertisseur ; et
la commande de la puissance de sortie de la batterie (110, 500) sur la base d'une variation de puissance de sortie du PCS (400) en fonction d'une variation de tension de la liaison CC ;
**caractérisé en ce que**
la commande de la puissance de sortie de la batterie (110, 500) comprend la commande de la batterie (110, 500) pour délivrer en sortie une puissance avec une valeur de puissance de crête prédéfinie si la puissance de sortie du PCS (400) dépasse une puissance nominale prédéfinie de la batterie (110, 500) ;
où la commande de la batterie (110, 500) pour délivrer en sortie une puissance avec la valeur de puissance de crête prédéfinie comprend :
la comparaison, sur une période de sortie de puissance de crête de la batterie (110, 500) égale ou supérieure à une première période prédéfinie, d'une différence entre la puissance de sortie du PCS (400) et la puissance de sortie de la batterie (110, 500) avec une valeur seuil prédéfinie ; et
la commande de la batterie (110, 500) pour produire une puissance à la puissance nominale dans un cas où la différence est inférieure à la valeur seuil prédéfinie.

7. Procédé selon la revendication 6, où la commande de la puissance de sortie de la batterie (110, 500) comprend la commande de la puissance de sortie de la batterie (110, 500) par commande d'un courant de la batterie (110, 500).

8. Procédé selon la revendication 6, où la commande de la batterie pour délivrer en sortie une puissance avec la valeur de puissance de crête prédéfinie comprend :
la commande de la batterie (110, 500) afin de modifier progressivement la puissance de sortie jusqu'à la puissance nominale dans un cas où la différence est supérieure ou égale à la valeur seuil prédéfinie.

9. Procédé selon la revendication 8, où la commande de la batterie (110, 500) pour modifier progressivement la puissance de sortie comprend :
la commande de la batterie (110, 500) pour délivrer en sortie une puissance par réduction progressive de la puissance de sortie d'une valeur de puissance seuil pendant une deuxième période prédéfinie sur la base de la puissance de crête de la batterie (110, 500).

10. Procédé selon la revendication 9, où la commande de la batterie (110, 500) pour modifier progressivement la puissance de sortie comprend :
la commande de la batterie (110, 500) pour délivrer en sortie une puissance à la puissance nominale si la période de sortie de puissance de crête dépasse la deuxième période prédéfinie.

11. Système de stockage d'énergie, comprenant :
un support de batteries comprenant une pluralité de batteries ;
une pluralité de convertisseurs, chaque convertisseur étant prévu pour exécuter une conversion courant continu/courant continu, CC/CC, conjointement avec une batterie respective du support de batteries ;
un système de conversion de puissance, PCS (400), connecté aux convertisseurs CC/CC (500) et à une charge ; où une liaison CC connecte une borne d'entrée du PCS et des bornes de sortie des convertisseurs ; et
un dispositif de commande de puissance connecté aux convertisseurs CC/CC (500) et prévu pour commander le fonctionnement des convertisseurs CC/CC (500),
où les convertisseurs sont prévus pour être actionnés par le dispositif de commande de puissance prévu pour détecter une tension de la liaison CC et pour commander la puissance de sortie du support de batterie sur la base d'une variation de puissance de sortie du PCS (400) en fonction d'une variation de tension de la liaison CC ;
**caractérisé en ce que**
le dispositif de commande de puissance est prévu pour activer la pluralité de convertisseurs afin de commander la batterie respective du support de batteries pour délivrer en sortie une puissance avec une valeur de puissance de crête prédéfinie si la puissance de sortie du PCS dépasse une puissance nominale prédéfinie de la batterie respective du support de batteries ;
et où le dispositif de commande de puissance est prévu pour activer la pluralité de convertisseurs pour :
si une période de sortie de puissance de crête de la batterie respective est égale ou supérieure à une première période prédéfinie, commander la batterie respective du support de batteries pour fournir une puissance de sortie à la puissance nominale dans le cas où une différence entre la puissance de sortie du PCS (400) et la puissance de sortie de la batterie respective du support de batteries est inférieure à une valeur de puissance seuil prédéfinie.

12. Système selon la revendication 11, où le dispositif de commande de puissance est prévu pour activer la pluralité de convertisseurs pour :
commander la batterie respective du support de batteries afin de modifier progressivement la puissance de sortie jusqu'à la puissance nominale dans le cas où la différence est égale ou supérieure à la valeur de puissance seuil prédéfinie.

13. Système selon la revendication 12, où le dispositif de commande de puissance est prévu pour activer la pluralité de convertisseurs pour :
commander la batterie respective du support de batteries afin de modifier progressivement la puissance de sortie par réduction de la puissance de sortie d'une valeur de puissance seuil pendant une deuxième période prédéfinie sur la base de la puissance de crête du support de batteries.

14. Système selon la revendication 13, où le dispositif de commande de puissance est prévu pour activer la pluralité de convertisseurs pour :
commander la batterie respective du support de batteries afin de délivrer en sortie une puissance à la puissance nominale si la période de sortie de puissance de crête dépasse la deuxième période prédéfinie.
